Europäisches Patentamt

European Patent Office

Office européen des brevets

(19)

(11) Veröffentlichungsnummer: **0 143 225**
**B1**

(12) **EUROPÄISCHE PATENTSCHRIFT**

(45) Veröffentlichungstag der Patentschrift: **28.11.90**

(51) Int. Cl.⁵: **H 03 D 9/06**

(21) Anmeldenummer: **84110802.0**

(22) Anmeldetag: **11.09.84**

(54) **Mikrowellen-Gegentaktfrequenzumsetzer.**

(30) Priorität: **24.11.83 DE 3342400**

(43) Veröffentlichungstag der Anmeldung:
**05.06.85 Patentblatt 85/23**

(45) Bekanntmachung des Hinweises auf die
Patenterteilung:
**28.11.90 Patentblatt 90/48**

(84) Benannte Vertragsstaaten:
**DE FR GB IT**

(56) Entgegenhaltungen:
**GB-A-2 006 539**
**US-A-3 949 327**
**US-A-4 348 773**

**NTZ, Band 33, Nr. 9, 1980, Seiten 590-592; W.
ULLMANN: "Frequenzumsetzer für Fernseh-
Rundfunk-Satelliten"**

(73) Patentinhaber: **ANT Nachrichtentechnik GmbH
Gerberstrasse 33
D-7150 Backnang (DE)**

(72) Erfinder: **Ullmann, Wolfgang, Dipl.-Ing.
Rietenauerweg 22
D-7150 Backnang (DE)**
Erfinder: **Gross, Walter, Dipl.-Ing.
Gänsheide 7
D-7151 Auenwald (DE)**

(74) Vertreter: **Wiechmann, Manfred, Dipl.-Ing.
ANT Nachrichtentechnik GmbH Gerberstrasse
33 Postfach 11 20
D-7150 Backnang (DE)**

(56) References cited:
**IEEE TRANSACTIONS ON MICROWAVE
THEORY AND TECHNIQUES, Band MTT-25, Nr.
12, Dezember 1977, Seiten 1048-1054; L.T.
YUAN: "Design and performance analysis of an
octave bandwidth waveguide mixer"**

## Beschreibung

Die Erfindung betrifft einen Mikrowellen-Gegentaktfrequenzumsetzer gemäß dem Oberbegriff des Patentanspruchs 1. Ein solcher Umsetzer ist bekannt (Sonderdruck aus NTZ, Bd. 33, (1980) Heft 9, Seiten 590 bis 591).

Verlustarme Direktumsetzer für Fernseh-Rundfunksatelliten werden in Hohlleitertechnik aufgebaut. Ein solcher Umsetzer setzt beispielsweise fünf frequenzmodulierte Empfangssignale innerhalb eines 400 MHz breiten Bandes von 19 GHz direkt in ein Sendesignal von 12 GHz um. Mögliche andere Frequenzkombinationen für diese Direktumsetzer sind z.B. 6 auf 4, 14 auf 4, 14 auf 12, 30 auf 4, 30 auf 20 oder 30 auf 12 GHz. Für Raumfahrtgeräte müssen Halbleitermischer sehr hohen Anforderungen bezüglich unerwünschten Mischprodukten genügen. Sie werden deshalb mit Eingangs- und Ausgangsfiltern beschaltet.

Leistungsstarke unerwünschte Mischprodukte können durch die Filter zu den Halbleitermischelementen reflektiert werden und umgemischt werden und somit zu einer Verbesserung des Konversionsverlustes beitragen, bei phasenrichtiger Reflexion. Neben diesen positiven Eigenschaften weisen diese Filter auch negative Eigenschaften auf: Durch die Ummischung entsteht eine stark gestörte Übertragungscharakteristik und es treten Fehlanpassungen auf. Mit zunehmender Bandbreite machen sich diese Sekundäreffekte der Filter immer stärker bemerkbar. Bei einem Umsetzer, dessen Eingangs- und Ausgangsfrequenzen sehr weit auseinanderliegen, beispielsweise 30/12 GHz, müssen Filter verwendet werden, welche möglichst niedrige Einfügungsdämpfung und einen sehr weiten Sperrbereich haben. Im Sonderdruck aus NTZ, Band 33, (1980), Heft 9 Seiten 590 bis 591, wurde vorgeschlagen, ein sogenanntes "Evanescent-Mode-Filter" auf der tieffrequenten Seite des Mischers vorzusehen. Nach IEEE Transactions on Microwave Theory and Techniques, Vol. MTT-19, No. 3, March 1971, Seiten 295 bis 308, insbesondere Seite 302, besitzt ein solches Evanescent-Mode-Filter ein parasitäres Bandpaßverhalten. Es ist daher für die Anwendung besonders breitbandiger Umsetzer nur bedingt brauchbar.

Aus der US-A-3,949,327 ist ein Hohlleiter-Tiefpaßfilter bekannt, bestehend aus kapazitiven Stegen und letztere verbindenden induktiven Abschnitten. Die induktiven Abschnitte sind für den Evanescentmode-Betrieb im Durchlaßbereich ausgelegt und die kapazitiven Stege für die Ausbreitung nur eines Wellentyps im Durchlaßbereich und im ersten Sperrbereich.

Aufgabe der Erfindung ist es, einen Mikrowellen-Gegentaktfrequenzumsetzer in Hohlleitertechnik gemäß dem Oberbegriff des Patentanspruchs 1 anzugeben, dessen Eingangsund Ausgangsfrequenzen relativ weit auseinanderliegen, insbesondere deren Verhältnis den Wert 1,5 übersteigt, und der hinsichtlich der Einfügungsdämpfung und der Unterdrückung von Mischprodukten günstiges Verhalten aufweist.

Erfindungsgemäß wird diese Aufgabe durch die Merkmale des Patentanspruchs 1 gelöst. In den Unteransprüchen sind vorteilhafte Ausgestaltungen der Erfindung aufgezeigt.

Durch die spezielle Ausbildung des Hohlleiterfilters für das Mikrowellensignal tiefer Frequenz läßt sich gutes Tiefpaßverhalten erreichen. Die Ersatzschaltung dieses Filters weist im Gegensatz zu einem "Evanescent-Mode-Filter" im wesentlichen nur Querkapazitäten und Längsinduktivitäten auf.

Wenn die Filterimpedanz relativ niedrig gewählt wird, ist zur Ankopplung des Filters an den Steghohlleiter zum Mischmodul keine zusätzliche Transformation nötig. Außerdem hat diese Wahl der Tiefpaßimpedanz (ca. 80 Ohm) und die Einbringung von Abstimmschrauben in die Stege eine kleine Baulänge zur Folge.

Das Mischmodul läßt Mikrowellensignale hoher und tiefer Frequenz in einem eindeutigen Mode, z.B. der $H_{10}$-Welle, hindurch. Der Umsetzer nach der Erfindung ist raumfahrtqualifiziert.

Anhand der Zeichnungen wird die Erfindung nun näher beschrieben. Es zeigen

Fig. 1 ein Blockschaltbild des Umsetzers,

Fig. 2 einen Querschnitt durch den Umsetzer,

Fig. 3 einen Schnitt durch das Filter für hochfrequente Signale,

Fig. 4 einen Schnitt durch ein Steghohlleiterverbindungsstück zwischen Mischmodul und Filter für hochfrequente Signale,

Fig. 5 einen Schnitt durch das Mischmodul,

Fig. 6 einen Schnitt durch das Filter für tieffrequente Signale,

Fig. 7 ein Ersatzschaltbild des Filters für tieffrequente Signale,

Fig. 8 einen maßstäblichen Querschnitt durch das Filter für tieffrequente Signale und

Fig. 9 eine Vorderansicht letzteren Filters.

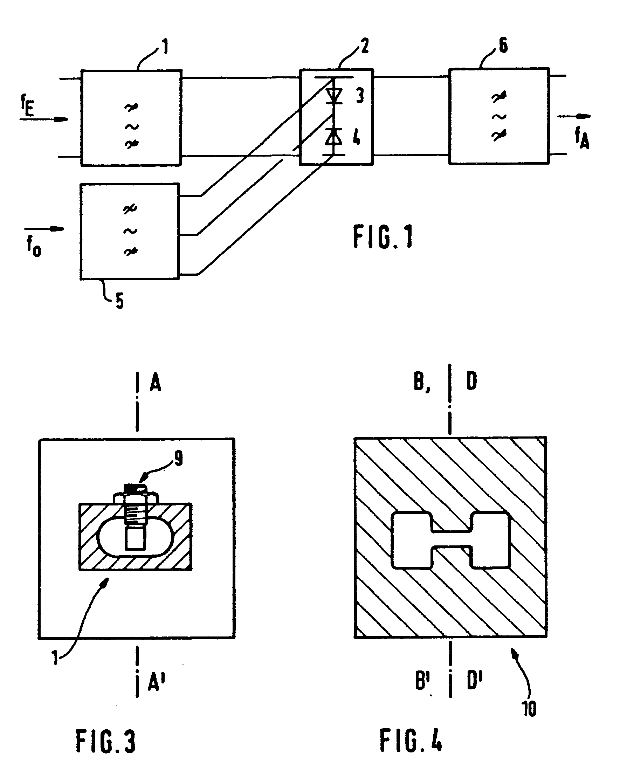

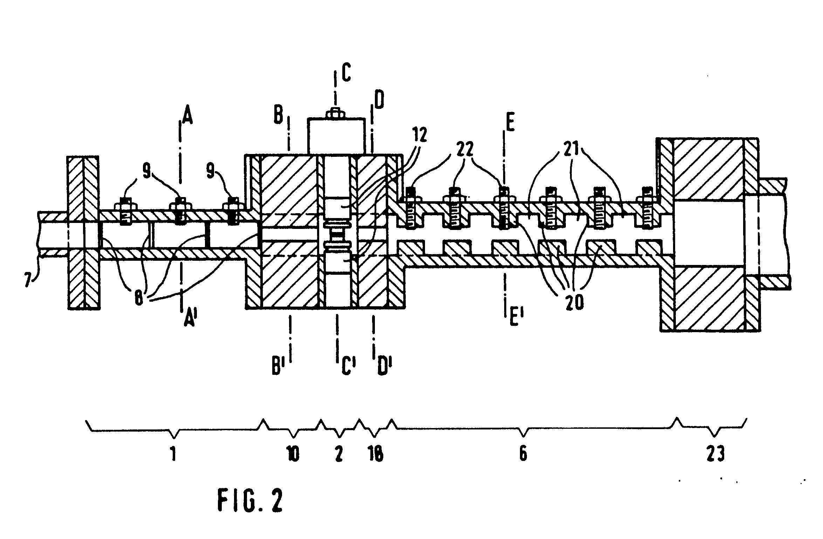

In Fig. 1 ist anhand eines Blockschaltbildes ein Mikrowellen-Gegentaktfrequenzumsetzer als Abwärtsmischer dargestellt. Ein 30 GHz-Eingangssignal $f_E$ (Mikrowellensignal hoher Frequenz) mit einer Bandbreite von beispielsweise 400 MHz wird über ein Filter 1 für dieses Mikrowellensignal hoher Frequenz zu einem Mischmodul 2 geführt. Das Mischmodul 2 enthält zwei Halbleitermischelemente 3 und 4, beispielsweise GaAs-Schottky-Dioden, die für den Gegentaktbetrieb geschaltet sind. Den Halbleitermischelementen 3 und 4 wird eine Oszillatorfrequenz $f_O$ über ein Oszillatorfilter 5 zugeführt. Die Oszillatorfrequenz $f_O$ ist bezüglich der Eingangsfrequenz $f_E$ so gewählt, daß eine Frequenzumsetzung auf 12 GHz erfolgt. Dieses 12 GHz-Signal $f_A$ (Mikrowellensignal tiefer Frequenz) wird mittels des Filters 6 von unerwünschten Mischprodukten befreit. Das Filter 6 besteht, wie nachfolgend noch näher erläutert wird, aus mittels Sperrhohlleiterabschnitten gekoppelten Steghohlleiterabschnitten mit kapazitivem Verhalten.

Der Querschnitt durch den Umsetzer, Fig. 2, zeigt den Aufbau im Einzelnen. Ein Hohlleiteranschlußstück 7 für 30 GHz ist eingangsseitig mit dem Filter 1 verbunden. Das Filter 1 besteht aus einem dreikreisigen Tschebyscheff-Bandfilter in Rechteckhohlleitertechnik für die $H_{10}$-Welle. Die Kopplung erfolgt mittels induktiven symmetrischen Blenden 8. Zur Abstimmung sind drei kapazitive Abstimmstifte 9, jeweils in der Mitte zwischen zwei Blenden angebracht. Diese Abstimmstifte 9 bestehen aus einfachen Abstimmschrauben, die in die obere Breitseite des Hohlleiters eingelassen sind, vgl. Schnittzeichnung Fig. 3. Die Ecken des Hohlleiterfilters 1 sind aus fertigungstechnischen Gründen stark abgerundet — quasi elliptisch.

An das Filter 1 für das 30 GHz-Signal schließt sich ein Steghohlleiterstück 10 an, das die Verbindung zwischen diesem Filter und dem Mischmodul 2 herstellt. Das Steghohlleiterstück 10 ist im Schnitt in Fig. 4 dargestellt. Die beiden Stege 11 befinden sich auf den Breitseiten des Rechteckhohlleiters für die $H_{10}$-Welle. Die Ausgangsimpedanz, die das Filter 1 für das 30 GHz-Signal bei 12 GHz hat, soll durch das Steghohlleiterstück 10 zwischen Mischmodul 2 und Filter 1 so in die Ebene der Halbleitermischelemente 3 und 4 transformiert werden, daß in dieser Ebene (Diodenebene) ein Leerlauf für das 12 GHz Signal entsteht. Die Länge des Steghohlleiterstückes 10 entspricht etwa $\lambda_H/8$, das sind etwa 6 mm bei 30 GHz Signalfrequenz, wobei die genaue Länge davon abhängt, welche Eingangsimpedanz das Filter 1 für das 12 GHz Signal hat.

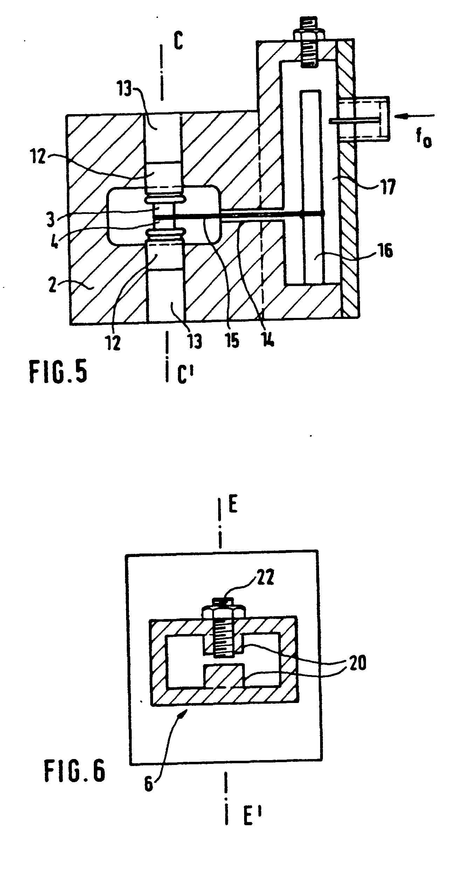

Das Mischmodul 2 ist als Dreitor aufgebaut, wobei zwei Tore (Zuführung des 30 GHz und Abführung des 12 GHz Signals) durch einen Steghohlleiter verbunden sind und das dritte Tor zur Zuführung der Oszillatorfrequenz $f_o$ in Koaxialtechnik ausgeführt ist. Das Mischmodul 2 nimmt zwei übereinander angeordnete Halbleitermischelemente 3 und 4 — GaAs-Schottky-Dioden — in Micropillgehäusen auf. Die voneinander abweisenden Enden der Dioden werden durch Befestigungsvorrichtungen — Goldbälge 12 — fixiert. Die Goldbälge 12 sind über Bohrungen 13 in das Mischmodulgehäuse eingebracht und dort eingelötet. Die Goldbälge 12 wie auch die Endflächen der Dioden 3 und 4 ragen soweit in den Hohlleiterrinnenraum des Mischmoduls 2, daß Stege entstehen, vgl. Fig. 2 und Fig. 5, die dem Mischmodul 2 die Form eines Steghohlleiters verleihen. Damit geringe Stoßstellen entstehen, muß die Form der Stege des Mischmoduls 2 mit der Form der Stege des Steghohlleiterstücks 10 annähernd übereinstimmen. Die Zuführung der Oszillatorfrequenz $f_o$ an die Dioden 3 und 4 erfolgt galvanisch. Dazu ist an der Hohlleiterschmalseite des Mischmoduls 2, vgl. Fig. 5, eine Bohrung 14 vorgesehen durch die ein Innenleiter 15 ragt. Ein Ende des Innenleiters 15 ist mit den aufeinanderzugerichteten Enden der Dioden 3 und 4 verbunden. Das andere Ende des Innenleiters 15 ist an den Innenleiter 16 eines koaxialen Topfkreises 17 angeschlossen (kapazitiv verkürzter $\lambda$-Resonator). Die Oszillatorfrequenz $f_o$ wird in diesen Topfkreis 17 seitlich eingekoppelt. Der Topfkreis 17 dient als Filter 5 für die Oszillatorfrequenz $f_o$. Mittels der Oszillatorfrequenz $f_o$ wird das 30 GHz Mikrowellensignal in den 12 GHz Bereich (Mikrowellensignal tiefer Frequenz) umgesetzt.

An das Mischmodul 2 in Steghohlleitertechnik schließt sich am Tor für das Mikrowellensignal tiefer Frequenz wieder ein Steghohlleiterstück 18 an, das die Verbindung zwischen dem Filter 6 für das Mikrowellensignal tiefer Frequenz und dem Mischmodul 2 herstellt. Der Querschnitt des Steghohlleiterstücks 18 entspricht dem Querschnitt des Steghohlleiterstücks 10. Die Eingangsimpedanz des 12 GHz Filters 6 soll durch das Steghohlleiterstück 18 zwischen Mischmodul 2 und 12 GHz Filter 6 so in die Diodenebene transformiert werden, daß hier für das 30 GHz Signal ein Leerlauf entsteht. Die Länge des Steghohlleiterstückes beträgt etwa $\lambda_H/4$. Dies sind etwa 4,5 mm bei 30 GHz. Die genaue Länge hängt von der Eingangsimpedanz des nachfolgenden Filters für das 30 GHz Signal ab. Bei Änderung der Filter 1 und 6 (z.B. Änderung der Bandbreite oder der Ankopplung) ändern sich auch die "Außer bandimpedanzen", die für die Länge der Steghohlleiterstücke 10 und 18 maßgebend sind. Das daran anschließende Filter 6 für das Mikrowellensignal tiefer Frequenz besteht aus Steghohlleiterabschnitten 20, die durch Sperrhohlleiterabschnitte 21 (cutoff-waveguide) gekoppelt sind. Die Steghohlleiterabschnitte 20 sind über Abstimmstifte 22 abstimmbar. Diese Abstimmstifte 22 bestehen, wie insbesondere die Schnittdarstellung in Fig. 6 zeigt, aus einfachen Abstimmschrauben. Sie sind jeweils von oben in der Mitte der Resonatorbreitseite eingebracht.

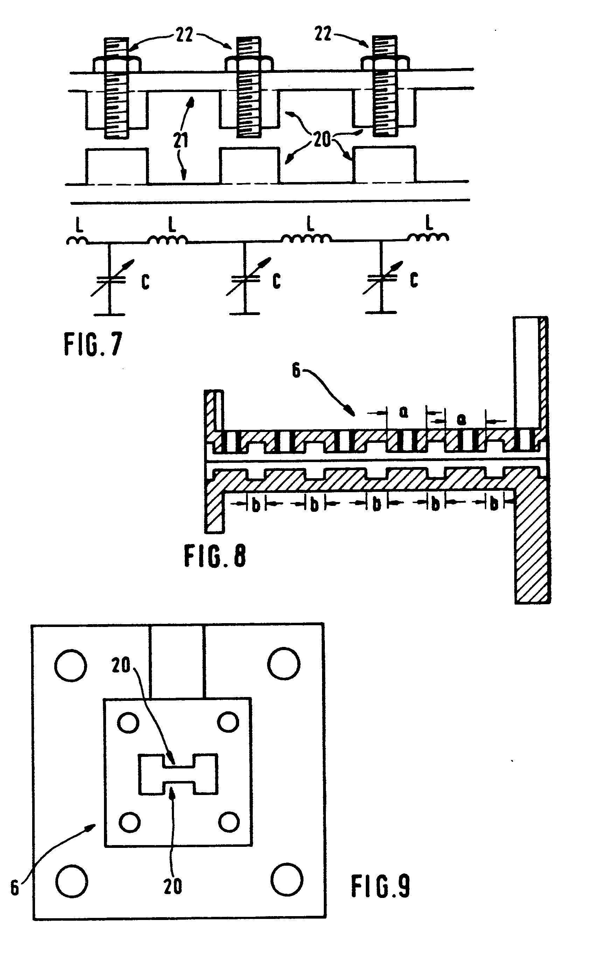

Fig. 7 zeigt das Ersatzschaltbild des Filters 6. Die Steghohlleiterabschnitte 20 mit den Abstimmschrauben 22 stellen abstimmbare Querkapazitäten C dar. Die Sperrhohlleiterabschnitte 21 stellen Längsinduktivitäten L dar.

Wie der Figur 8 zu entnehmen ist, besitzen die Steghohlleiterabschnitte 20 die gleiche Länge a = 5 mm. Die Sperrhohlleiterabschnitte 21 variieren jedoch in ihrer Länge b zwischen 2 und 2,5 mm. An den Enden des Filters 6 sind die Längen b am kleinsten und in der Mitte des Filters am größten.

Wie Fig. 9 zeigt, sind die Stege 4 mm breit und 3 mm hoch. Sie besitzen einen Abstand von 2 mm zueinander. Am mischmodulfernen Ende des Filter 6 befindet sich ein ein- oder mehrstufiger $\lambda/4$-Hohlleitertransformator 23.

## Patentansprüche

1. Mikrowellen-Gegentaktfrequenzumsetzer in Hohlleitertechnik für breitbandige Signale mit einem aus einem Hohlleiterstück bestehenden Mischmodul (2), in welchem paarweise Halbleitermischelemente (3, 4) angeordnet sind, wobei ein Mikrowellensignal tiefer Frequenz unter Umgehung einer Zwischenfrequenzumsetzung direkt in ein Mikrowellensignal hoher Frequenz umgesetzt wird oder umgekehrt, und wobei sich an das Mischmodul (2) jeweils ein Hohlleiterfilter (6) für das Mikrowellensignal hoher bzw. tiefer, Frequenz anschließt, dadurch gekennzeichnet, daß das Hohlleiterfilter (6) für das Mikrowellensignal tiefer Frequenz aus mittels Sperrhohlleiterabschnitten (21) gekoppelten Steghohlleiterabschnitten (20) aufgebaut ist und daß die Befestigungsvorrichtungen (12) für die Halbleitermischelemente (3, 4) sowie die Halbleitermischelemente (3, 4) selbst derart ausgebildet sind, daß das Mischmodul (2) die Form eines Steghohlleiters annimmt, der die Mikrowellensignale hoher und tiefer Frequenz in einem eindeutigen Mode durchläßt und dessen Stegform mit der Stegform anschließender Steghohlleiterstücke (10, 18) annähernd übereinstimmt.

2. Mikrowellen-Gegentaktfrequenzumsetzer nach Anspruch 1, dadurch gekennzeichnet, daß die Steghohlleiterabschnitte (20) Abstimmstifte (22) aufweisen.

3. Mikrowellen-Gegentaktfrequenzumsetzer nach Anspruch 1 oder 2, dadurch gekennzeichnet, daß die Impedanz des Hohlleiterfilters für das Mikrowellensignal tiefer Frequenz klein gewählt ist.

4. Mikrowellen-Gegentaktfrequenzumsetzer nach Anspruch 1, 2 oder 3, dadurch gekennzeichnet, daß an die durch Sperrhohlleiterabschnitte (21) gekoppelten Steghohlleiterabschnitte (20) am mischmodulfernen Ende ein ein- oder mehrstufiger λ/4-Hohlleitertransformator (23) angeschlossen ist.

5. Mikrowellen-Gegentaktfrequenzumsetzer nach Anspruch 1 oder 4, dadurch gekennzeichnet, daß zwischen dem Mischmodul (2) einerseits und dem Hohlleiterfilter (6) für das Mikrowellensignal tiefer Frequenz andererseits ein Steghohlleiterstück (18), das den gleichen Querschnitt wie der Steghohlleiter des Mischmoduls (2) aufweist, eingefügt ist, wobei das eingefügte Steghohlleiterstück (18) so bemessen ist, daß ein Leerlauf vom Ausgang des Hohlleiterfilters (6) für Signale hoher Frequenz in die Ebene der Halbleitermischelemente (3, 4) transformiert wird.

6. Mikrowellen-Gegentaktfrequenzumsetzer nach einem der Ansprüche 1, 3, 4 oder 5, dadurch gekennzeichnet, daß zwischen dem Mischmodul (2) einerseits und dem Hohlleiterfilter (1) für das Mikrowellensignal hoher Frequenz andererseits ein Steghohlleiterstück (18), das den gleichen Querschnitt wie der Steghohlleiter des Mischmoduls (2) aufweist, eingefügt ist, wobei das eingefügte Steghohlleiterstück (10) so bemessen ist, daß ein Leerlauf vom Ausgang des Hohlleiterfilters (1) für Signale tiefer Frequenz in die Ebene der Halbleitermischelemente (3, 4) transformiert wird.

**Revendications**

1. Convertisseur de fréquence en mode symétrique pour signal micro-ondes, en technique guide d'ondes, pour signaux large bande, comportant un module mélangeur (2) qui est constitué d'un élément de guide d'ondes et dans lequel sont disposés, par paire, des éléments mélangeurs à semi-conducteurs (3, 4), dans lequel un signal micro-ondes de basse fréquence est directement transformé en un signal micro-ondes de haute fréquence, ou inversement, en évitant une conversion en une fréquence intermédiaire, et dans lequel, au module mélangeur (2), se raccorde respectivement un filtre en guide d'ondes (6) pour le signal micro-ondes de haute ou de basse fréquence, caractérisé par le fait que le filtre en guide d'ondes (6) pour le signal micro-ondes de basse fréquence est constitué de tronçons de guide d'ondes à moulures (20) couplés au moyen de tronçons de guide d'ondes de déconnexion (21) et par le fait que les dispositifs de fixation (12) pour les éléments mélangeurs à semi-conducteurs (3, 4), ainsi que les éléments mélangeurs à semi-conducteurs (3, 4) eux-mêmes, sont conçus de façon telle que le module mélangeur (2) prend la forme d'un guide d'ondes à moulures qui transmet les signaux micro-ondes de haute et de basse fréquence en mode univoque et dont la forme des moulures coïncide approximativement avec la forme des moulures des éléments de guide d'ondes à moulures voisins (10, 18).

2. Convertisseur de fréquence en mode symétrique pour signal micro-ondes selon la revendication 1, caractérisé par le fait que les tronçons de guide d'ondes à moulures (20) présentent des tiges d'adaptation (22).

3. Convertisseur de fréquence en mode symétrique pour signal micro-ondes selon la revendication 1 ou 2, caractérisé par le fait que l'on choisit petite l'impédance du filtre en guide d'ondes pour le signal micro-ondes de basse fréquence.

4. Convertisseur de fréquence en mode symétrique pour signal micro-ondes selon la revendication 1, 2 ou 3, caractérisé par le fait qu'aux tronçons de guide d'ondes à moulures (20) couplés par des tronçons de guide d'ondes de déconnexion (21) est relié, à l'extrémité éloignée du module mélangeur, un transformateur en guide d'ondes λ/4 (23) à un ou plusieurs étages.

5. Convertisseur de fréquence en mode symétrique pour signal micro-ondes selon la revendication 1 ou 4, caractérisé par le fait qu'entre le module mélangeur (2) d'une part et le filtre en guide d'ondes (6) pour le signal micro-ondes de basse fréquence d'autre part est inséré un élément de guide d'ondes à moulures (18) qui présente la même section que le guide d'ondes à moulures du module mélangeur (2), étant précisé que l'élément de guide d'ondes à moulures, ainsi inséré (18), est dimensionné de façon qu'un circuit ouvert apparaisse à la sortie du filtre en guide d'ondes (6) prévu pour les signaux de haute fréquence, dans le plan des éléments mélangeurs à semi-conducteurs (3, 4).

6. Convertisseur de fréquence en mode symétrique pour signal micro-ondes selon l'une des revendications 1, 3, 4 ou 5, caractérisé par le fait qu'entre le module mélangeur (2) d'une part et le filtre en guide d'ondes (1) pour le signal micro-ondes de haute fréquence d'autre part est inséré un élément de guide d'ondes à moulures (10) qui présente la même section que le guide d'ondes à moulures du module mélangeur (2), étant précisé que l'élément de guide d'ondes à moulures (10), ainsi inséré, est dimensionné pour qu'un circuit ouvert apparaisse à la sortie du filtre en guide d'ondes (1) prévu pour les signaux de basse fréquence, dans le plan des éléments mélangeurs à semi-conducteurs (3, 4).

**Claims**

1. A microwave push-pull frequency converter in waveguide form for broadband signals, the converter being composed of a converter module (2) in the form of a waveguide piece in which pairs of semiconductor converter elements (3, 4) are disposed, with a low frequency microwave signal being converted directly — without intermediate frequency conversion — into a high frequency microwave signal or vice versa and with the converter module (2) being followed by a waveguide filter (6) for the high frequency microwave signal and for the low frequency microwave signal, respectively, characterised in that the waveguide filter (6) for the low frequency microwave signal is composed of ridged waveguide sections (20) which are coupled together by means of blocking waveguide sections (21), and the fastening devices (12) for the semiconductor converter elements (3, 4) as well as the semiconductor converter elements (3, 4) themselves are designed in such a manner that the converter module (2) takes on the shape of a ridged waveguide which permits the high and low frequency microwave signals to pass in a single mode and whose ridged shape approximately coincides with the ridged shape of subsequent ridged waveguide sections.

2. A microwave push-pull frequency converter according to claim 1, characterised in that the ridged waveguide sections (20) are equipped with tuning pins (22).

3. A microwave push-pull frequency converter according to claim 1 or 2, characterised in that the impedance of the waveguide filter for the low frequency signal is selected to be low.

4. A microwave push-pull frequency converter according to claim 1, 2 or 3, characterised in that, at the end remote from the converter module, a single or multi-stage λ/4 waveguide transformer (23) is connected to the ridged waveguide sections (20), which are coupled together by blocking waveguide sections (21).

5. A microwave push-pull frequency converter according to claim 1 or 4, characterised in that between the converter module (2), on the one hand, and the waveguide filter (6) for the low frequency microwave signal, on the other hand, there is inserted a ridged waveguide piece (18) which has the same cross section as the ridged waveguide of converter module (2), with the inserted ridged waveguide section (18) having such dimensions that idling from the output of the waveguide filter (6) for high frequency signals is transformed into the plane of the semiconductor converter elements (3, 4).

6. A microwave push-pull frequency converter according to claim 1, 3, 4 or 5, characterised in that between the converter module (2), on the one hand, and the waveguide filter (1) for the high frequency microwave signal, on the other hand, a ridged waveguide piece (18) [sic] is inserted which has the same cross section as the ridged waveguide of the converter module (2), with the inserted ridged waveguide piece (10) being dimensioned in such a manner that idling from the output of the waveguide filter (1) for low frequency signals is transformed into the plane of the semiconductor converter elements (3, 4).

FIG.1

FIG.3

FIG.4

FIG. 2

FIG.5

FIG.6

FIG.7

FIG.8

FIG.9